# DEMANDE DE BREVET EUROPEEN

(11) **EP 4 125 309 A1**
(43) Date de publication de la demande: **01.02.2023**
(21) Numéro de dépôt: 22187479.5
(22) Date de dépôt: 28.07.2022
(51) Int. Cl.: H05K 1/02, H05K 3/42

(54) **CARTE DE CIRCUITS IMPRIMES MULTICOUCHE**

(30) Priorité: 29.07.2021 FR 2108248
(71) Demandeur: THALES, 92400 Courbevoie (FR)
(72) Inventeur: AUPEE, Geoffroy, 76520 YMARE (FR); MICHAUD, Pierre-Yves, 76520 YMARE (FR)
(74) Mandataire: Atout PI Laplace

(57) **Abrégé**

Les modes de réalisation de l'invention fournissent une carte de circuits imprimés multicouche (10) destinée à connecter des composants électroniques (304), la carte (10) comprenant un empilement de plusieurs couches conductrices (100), les couches conductrices (100) comprenant deux couches en surface (101) et une ou plusieurs couches internes (102), la carte (10) comprenant un ou plusieurs trous de type contre-percé (202), chaque trou de type contre-percé (202) comprenant une partie avec métallisation (2021) s'ouvrant sur l'une des deux couches en surface (101) et une partie sans métallisation (2022) s'ouvrant sur l'autre couche en surface (101), la carte de circuits imprimés multicouche (10) peut avantageusement comprendre une ou plusieurs pastilles métalliques (301), chaque pastille métallique (301) étant assemblée sur l'une des deux couches en surface (101) de manière à venir occulter un trou de type contre-percé (202) correspondant au niveau de sa partie sans métallisation (2022).

## Description

La présente invention concerne de manière générale les circuits imprimés pour les systèmes électroniques et en particulier une carte de circuits imprimés multicouche et un procédé de fabrication de la carte de circuits imprimés multicouche.

Les systèmes électroniques mettent classiquement en œuvre des traitements complexes impactant l'encombrement et la consommation d'énergie de tels systèmes. Par exemple, le fonctionnement d'un système électronique de type radar repose généralement sur des signaux électromagnétiques générés et émis dans l'espace au moyen d'un module d'émission équipé d'une antenne dédiée. Le radar comprend en outre un module de réception destiné à détecter des signaux électromagnétiques réfléchis par des cibles, et un module de traitement destiné à déterminer à partir des signaux détectés des informations relatives aux cibles telles que leur position et leur vitesse de déplacement.

Les radars peuvent être fixes au sol, embarqués sur un véhicule terrestre ou sur un navire, ou aéroportés au moyen d'un aéronef. Dans tous les cas, le radar doit satisfaire de nombreuses contraintes liées, en particulier, à l'encombrement. En effet, dans le domaine des radars à antennes actives par exemple, l'orientation est d'intégrer de plus en plus de fonctionnalités dans la partie antenne du radar. Au départ limitée aux fonctions hyperfréquences (émission et réception de signaux avec leurs servitudes), la partie antenne du radar doit héberger une partie toujours croissante du traitement numérique des signaux. En parallèle, le radar doit être capable de mettre œuvre de plus en plus de fonctionnalités afin de s'adapter aux cibles d'intérêt qui sont de plus en plus petites et/ou manœuvrantes.

Afin de satisfaire les contraintes d'encombrement dans un radar, il est connu d'utiliser une ou plusieurs cartes de circuits imprimés monocouche comprenant chacune plusieurs composants électroniques. Les composants électroniques d'une même carte de circuits imprimés sont électriquement connectés au moyen de pistes électriques et selon un schéma électrique donné de manière à réaliser des fonctions électroniques sur les différents signaux requis dans le fonctionnement du radar. De telles fonctions électroniques comprennent, par exemple et sans limitation, la génération de signaux, le filtrage, la modulation et la transposition en fréquence. Ainsi, les signaux électriques circulant dans les pistes électriques d'une carte de circuits imprimés monocouche peuvent être de différentes formes (numérique ou analogique), de différentes fréquences (signaux en bande de base et signaux radiofréquences) et/ou de différentes puissances. Cependant, les dimensions d'une carte de circuits imprimés monocouche est fortement liés au nombre et à la longueur des pistes électriques connectant les différents composants électroniques agencés sur la carte de circuits imprimés monocouche. Ceci rend les cartes de circuits imprimés monocouche incompatibles avec les radars d'aujourd'hui qui incorporent un nombre significatif de fonctions électroniques requérant un nombre significatif de composants électroniques.

Afin de pallier les limitations liées à l'utilisation d'une carte de circuits imprimés monocouche dans un radar, il est connu d'utiliser une carte de circuits imprimés multicouche comprenant un empilement de plusieurs couches (deux couches en surface et une ou plusieurs couches internes). Dans ce cas, un composant électronique peut être connectés à d'autres composants électroniques au moyen de pistes électriques réalisés dans une ou dans plusieurs couches de la carte de circuits imprimés multicouche. Pour ce faire, des trous métallisés sont généralement utilisés pour assurer la connexion électrique entre les différentes couches de la carte de circuits imprimés multicouche. Par exemple, un trou métallisé de type traversant peut être utilisé pour connecter électriquement toutes les couches de la carte de circuits imprimés multicouche. Il est également connu d'utiliser un trou métallisé de type contre-percé pour connecter électriquement l'une des deux couches en surface à une ou à plusieurs couches internes. De manière générale, un trou de type contre-percé est réalisé à partir d'un trou métallisé de type traversant en supprimant la métallisation inutile ou inutilisée responsable de certains phénomènes de réflexions et/ou de perturbations des signaux utiles. Cependant, dans certains cas, le contre-perçage peut être à l'origine de rayonnements électromagnétiques parasites qui peuvent altérer localement le fonctionnement de certains composants électroniques mis en œuvre dans la carte de circuits imprimés multicouche.

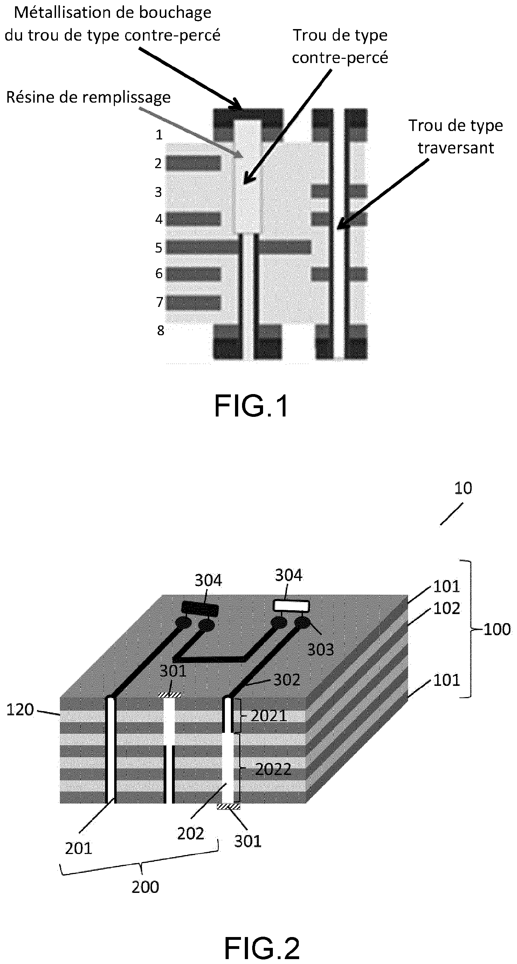

Une solution connue pour supprimer les rayonnements électromagnétiques parasites est illustrée sur la figure 1. Une telle solution connue consiste à remplir chaque trou de type contre-percé par une résine non conductrice d'électricité, et de boucher le trou de type contre-percé ainsi rempli par une métallisation déposée suivant un procédé similaire à celui mis en œuvre pour la réalisation des pistes métalliques d'interconnexion entre composants électroniques montés en surface. Cependant, une telle solution connue est complexe à réaliser et dégrade considérablement le rendement de fabrication des cartes de circuits imprimés multicouche. En effet, la résine de remplissage peut facilement pénétrer dans d'autres types de trous métallisés tels que les trous métallisés de type traversant, ce qui nécessite des étapes supplémentaires pour les libérer de la résine. En outre, la réalisation des métallisations de bouchage requiert le dépôt de couches métalliques supplémentaires sur les couches en surface de la carte de circuits imprimés multicouche, l'épaisseur finale de métallisation devenant importante et dégradant la finesse et les tolérances de gravure.

Ainsi, il existe un besoin pour une carte de circuits imprimés multicouche améliorée.

### Définition générale de l'invention

A cet effet, la présente invention fournit une carte de circuits imprimés multicouche destinée à connecter des composants électroniques, la carte de circuits imprimés multicouche comprenant un empilement de plusieurs couches conductrices, les couches conductrices comprenant deux couches en surface et une ou plusieurs couches internes, la séparation entre deux couches conductrices voisines étant assurée au moyen d'une couche électriquement isolante, la carte de circuits imprimés comprenant un ou plusieurs trous de type contre-percé, chaque trou de type contre-percé étant configuré pour connecter électriquement l'une des deux couches en surface à une ou à plusieurs couches internes et comprenant une partie avec métallisation s'ouvrant sur l'une des deux couches en surface et une partie sans métallisation s'ouvrant sur l'autre couche en surface, la partie avec métallisation et la partie sans métallisation d'un trou de type contre-percé s'étendant dans une direction perpendiculaire à un plan d'empilement de couches. Avantageusement, la carte de circuits imprimés multicouche comprend en outre une ou plusieurs pastilles métalliques, chaque pastille métallique étant assemblée sur l'une des deux couches en surface de manière à venir occulter un trou de type contre-percé correspondant au niveau de sa partie sans métallisation.

Dans un mode de réalisation, des rayonnements électromagnétiques parasites sont susceptibles de se former à l'intérieur des trous de type contre-percé, et les pastilles métalliques peuvent être choisies de manière à bloquer, au moins partiellement, la propagation des rayonnements électromagnétiques parasites en dehors des trous de type contre-percé.

Dans un autre mode de réalisation, des rayonnements électromagnétiques parasites sont susceptibles de pénétrer à l'intérieur des trous de type contre-percé, et les pastilles métalliques peuvent être choisies de manière à bloquer, au moins partiellement, la propagation des rayonnements électromagnétiques parasites à l'intérieur des trous de type contre-percé.

Avantageusement, des propriétés géométriques d'une pastille métallique peuvent être choisies en fonction d'une ou plusieurs caractéristiques des rayonnements électromagnétiques parasites susceptibles de se former et/ou de pénétrer dans le trou de type contre-percé correspondant.

En variante, des propriétés électriques d'une pastille métallique peuvent être choisies en fonction d'une ou plusieurs caractéristiques des rayonnements électromagnétiques parasites susceptibles de se former et/ou de pénétrer dans le trou de type contre-percé correspondant.

Dans un mode de réalisation, les pastilles métalliques peuvent être identiques.

Dans un autre mode de réalisation, les pastilles métalliques peuvent être des composants passifs ne requérant pas une alimentation électrique.

Il est en outre proposé un procédé de fabrication d'une carte de circuits imprimés multicouche et de report de composants, la carte de circuits imprimés multicouche étant destinée à connecter des composants électroniques. Avantageusement, le procédé comprend les étapes consistant à :
- réaliser un empilement de plusieurs couches conductrices, les couches conductrices comprenant deux couches en surface et une ou plusieurs couches internes, la séparation entre deux couches conductrices voisines étant assurée au moyen d'une couche isolante ;
- réaliser des connexions électriques entre les couches conductrices au moyen d'un ou plusieurs trous métallisés de type traversant ;
- transformer au moins un trou métallisé de type traversant en un trou de type contre-percé, le trou de type contre-percé comprenant une partie avec métallisation s'ouvrant sur l'une des deux couches en surface et une partie sans métallisation s'ouvrant sur l'autre couche en surface, la partie avec métallisation et la partie sans métallisation d'un trou de type contre-percé s'étendant dans une direction perpendiculaire à un plan d'empilement de couches ;
- réaliser des pistes électriques et des pastilles de connexion sur au moins l'une des deux couches en surface.

Avantageusement, le procédé de fabrication d'une carte de circuits imprimés multicouche et de report de composants peut en outre comprendre des étapes consistant à :
- assembler une ou plusieurs pastilles métalliques sur l'une ou sur les deux couches en surface, chaque pastille métallique étant assemblée de manière à venir occulter un trou de type contre-percé correspondant au niveau de sa partie sans métallisation.
- assembler un ou plusieurs composants électroniques sur des pastilles de connexion appartenant à l'une ou aux deux couches en surface.

### Brève description des figures

D'autres caractéristiques et avantages de l'invention apparaîtront à l'aide de la description qui suit et des figures dans lesquels :
La figure 1 illustre un trou de type contre-percé, selon une solution de l'état de la technique ;
La figure 2 représente une carte de circuits imprimés multicouche, selon des modes de réalisation de l'invention ;
La figure 3 représente un procédé de fabrication d'une carte de circuits imprimés multicouche et de report de composants, selon des modes de réalisation de l'invention ;
Les figures 4A à 4C illustrent les étapes mises en œuvre pour assembler une pastille métallique sur une couche en surface d'une carte de circuits imprimés multicouche, selon des modes de réalisation de l'invention ;
Les figrues 5A à 5G illustrent les étapes de réalisation d'un trou de type contre-percé et d'un trou de type traversant, selon une solution de l'état de la technique ; et
Les figures 6A à 6D illustrent les étapes de réalisation d'un trou de type contre-percé et d'un trou de type traversant, selon des modes de réalisation de l'invention.

### Description détaillée

La carte de circuits imprimés multicouche 10 selon les divers modes de réalisation de l'invention est destinée à connecter électriquement des composants électroniques 304 et à leur permettre d'échanger des signaux électriques de différentes formes (numérique ou analogique), de différentes fréquences (signaux en bande de base et signaux radiofréquences) et/ou de différentes puissances.

La figure 2 représente une carte de circuits imprimés multicouche 10, selon des modes de réalisation de l'invention. La carte de circuits imprimés multicouche 10 comprend un empilement de plusieurs couches conductrices 100, la séparation entre deux couches conductrices 100 voisines étant assurée au moyen d'une couche électriquement isolante 120 à base d'un ou plusieurs matériaux isolants. Les couches conductrices 100 comprennent deux couches en surface 101 et une ou plusieurs couches internes 102. Par ailleurs, chacune des couches conductrices 100 comprend un ensemble de pistes électriques 302 destinées à connecter des composants électroniques 304 reportés, c'est-à-dire brasés, sur une ou plusieurs couches conductrices 100 de la carte de circuits imprimés multicouche 10. La carte de circuits imprimés multicouche 10 comprend en outre un ou plusieurs trous de connexion 200, appelés aussi vias, permettant d'établir des connexions électriques entre les différentes couches conductrices 100 de la carte de circuits imprimés multicouche 10. Par exemple, les pistes électriques 302 conjointement avec les trous de connexion 200 permettent d'établir une connexion électrique entre deux composants électroniques 304 reportés sur une même couche ou reportés sur deux couches différentes de la carte de circuits imprimés multicouche 10. Par ailleurs, la carte de circuits imprimés multicouche 10 comprend au moins un trou de type contre-percé 202. Un trou de type contre-percé 202 permet de connecter l'une des deux couches en surface 101 à une ou plusieurs couches internes 102 en comprenant une partie avec métallisation 2021 traversant perpendiculairement les couches conductrices 100 à connecter et s'ouvrant, c'est-à-dire se terminant, sur la couche en surface 101 considérée. Le trou de type contre-percé 202 comprend en outre une partie sans métallisation 2022 traversant les autres couches conductrices 100 et s'ouvrant sur l'autre couche en surface 101. D'un point de vue industriel, un trou de type contre-percé 202 peut être obtenu en réalisant tout d'abord un trou métallisé de type traversant 201 dont la surface intérieure est totalement métallisée, c'est-à-dire recouverte par un métal, avant de venir enlever une partie de la métallisation intérieure selon une direction perpendiculaire au plan d'empilement de couches. Dans les modes de réalisation de l'invention, la carte de circuits imprimés multicouche 10 comprend en outre une ou plusieurs pastilles métalliques 301. Chacune des pastilles métalliques 301 est reportée sur l'une des deux couches en surface 101 de manière à venir occulter un trou de type contre-percé 202 correspondant au niveau de sa partie sans métallisation 2022. Chaque pastille métallique 301 est une pastille métallique d'isolation, capable de bloquer les rayonnements électromagnétiques parasites.

Chaque couche de la carte de circuits imprimés multicouche 10 comprend en outre des pastilles de connexion 303 qui correspondent, par exemple, aux terminaisons des pistes électriques 302 de la couche conductrice 100 considérée. Une pastille de connexion 303 peut être perforée pour établir une connexion électrique entre deux ou plusieurs couches conductrices 100 moyennant un via ou pour établir une connexion électrique entre des composants électroniques 304. De manière alternative, une pastille de connexion 303 peut ne pas être perforée en étant destinée à braser des composants électroniques 304 montés en surface.

Dans des modes de réalisation de l'invention, des rayonnements électromagnétiques parasites sont susceptibles de se former à l'intérieur d'un trou de type contre-percé 202. L'origine d'un tel rayonnement électromagnétique parasite peut, par exemple et sans limitation, être la partie avec métallisation 2021 du trou de type contre-percé 202 qui peut agir comme une antenne en rayonnant les ondes électromagnétiques qui la traversent. Dans de tels modes de réalisation de l'invention, la pastille métallique 301 occultant le trou de type contre-percé 202 est choisie de manière à bloquer, au moins partiellement, la propagation de tels rayonnements électromagnétiques parasites en dehors du trou de type contre-percé 202 correspondant. Avantageusement, chaque pastille métallique 301 mise en œuvre dans la carte de circuits imprimés multicouche 10 est choisie de manière à bloquer totalement la propagation de rayonnements électromagnétiques parasites en dehors du trou de type contre-percé 202 correspondant.

Dans d'autres modes de réalisation de l'invention, des rayonnements électromagnétiques parasites sont susceptibles de se former à l'extérieur d'un trou de type contre-percé 202. Dans de tels modes de réalisation de l'invention, la pastille métallique 301 occultant le trou de type contre-percé 202 est choisie de manière à bloquer, au moins partiellement, la pénétration de tels rayonnements électromagnétiques parasites à l'intérieur du trou de type contre-percé 202 correspondant.

Avantageusement, les pastilles métalliques 301 occultant les trous de type contre-percé 202 de la carte de circuits imprimés multicouche 10 peuvent être identiques, c'est-à-dire que les pastilles métalliques 301 peuvent présenter les mêmes propriétés géométriques, en particulier la même épaisseur qui est mesurée perpendiculairement au plan d'empilement de couches.

Dans des modes de réalisation de l'invention, les propriétés géométriques d'une pastille métallique 301 occultant un trou de type contre-percé 202 peuvent être choisies en fonction d'une ou plusieurs caractéristiques des rayonnements électromagnétiques parasites susceptibles de se former dans ou à l'extérieur du trou de type contre-percé 202 correspondant. Par exemple, l'épaisseur d'une pastille métallique 301 peut être plusieurs fois supérieure, typiquement cent fois supérieure, à l'épaisseur de peau associée aux rayonnements électromagnétiques parasites considérés, l'épaisseur de peau étant dépendante de la fréquence des rayonnements électromagnétiques parasites considérés.

Dans d'autres modes de réalisation de l'invention, les propriétés électriques d'une pastille métallique 301 occultant un trou de type contre-percé 202 peuvent être choisies en fonction d'une ou plusieurs caractéristiques des rayonnements électromagnétiques parasites susceptibles de se former dans ou à l'extérieur du trou de type contre-percé 202 correspondant. De telles propriétés électriques comprennent, par exemple et sans limitation, la conductivité électrique de la pastille métallique 301.

Avantageusement, les pastilles métalliques 301 occultant les trous de type contre-percé 202 de la carte de circuits imprimés multicouche 10 sont des composants passifs ne requérant pas une alimentation électrique. Par ailleurs, une pastille métallique 301 reportée sur l'une des deux couches en surface 101 de la carte de circuits imprimés multicouche 10 peut être électriquement isolée de toutes les autres pastilles métalliques 301 reportées sur la même couche en surface 101.

Dans des modes de réalisation de l'invention, une ou plusieurs pastilles métalliques 301 peuvent chacune être homogène en termes de composition chimique, c'est-à-dire être composée d'un seul élément chimique qui peut être un métal comme le cuivre ou l'aluminium. Alternativement, une ou plusieurs pastilles métalliques 301 peuvent chacune être composée d'un alliage de plusieurs éléments chimiques.

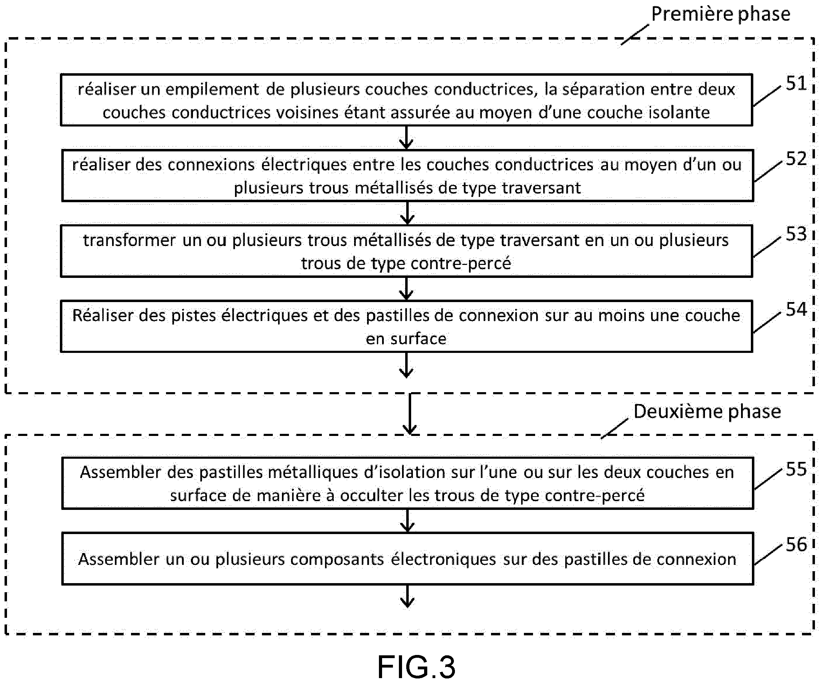

La figure 3 représente un procédé de fabrication d'une carte de circuits imprimés multicouche 10 et de report de composants, selon des modes de réalisation de l'invention. Le procédé de fabrication comprend une première phase consistant à fabriquer la carte de circuits imprimés multicouche 100 et une deuxième phase consistant à reporter des pastilles métalliques 301 et des composants électroniques 304 sur la carte de circuits imprimés multicouche 100 ainsi fabriquée. La première phase comprend les étapes 51 à 54 et la deuxième phase comprend les étapes 55 et 56, les étapes 51 à 56 étant décrites ci-après. Le procédé de fabrication selon les divers modes de réalisation de l'invention s'applique à des cartes de circuits imprimés présentant un nombre quelconque de couches conductrices 100, typiquement supérieur à trois.

A l'étape 51, un empilement de plusieurs couches conductrices 100 est réalisé, la séparation entre deux couches conductrices 100 voisines étant assurée au moyen d'une couche isolante 120 à base d'un ou plusieurs matériaux isolants. Les couches conductrices 100 comprennent deux couches en surface 101 et une ou plusieurs couches internes 102. Chaque couche conductrice 100, en particulier chaque couche interne 102, peut comprendre un ensemble de pistes électriques 302 et un ensemble de pastilles de connexion 303 préalablement réalisés selon un schéma électronique donné. L'étape 301 peut en outre consister à réaliser des connexions électriques entre les couches internes 102 au moyen d'un ou plusieurs trous de type enterré et à réaliser des connexions électriques entre les couches en surface 101 et les couches internes 102 au moyen d'un ou plusieurs trous de type borgne. De manière générale, un trou de type enterré ou de type borgne est obtenu en réalisant un trou métallisé de type traversant sur un sous-empilement de couches conductrices 100. Par exemple, le sous-empilement de couches conductrices 100 d'un trou de type enterré ne comprend que des couches conductrices internes 101 et leur couche électriquement isolante 120 de la carte de circuits imprimés multicouche 10.

A l'étape 52, des connexions électriques entre les couches conductrices 100 sont réalisées au moyen d'un ou plusieurs trous métallisés de type traversant 201. La réalisation d'un trou métallisé de type traversant 201 consiste à percer un trou à travers toutes les couches mises en œuvre, avant de venir déposer une couche d'un métal tel quel le cuivre à l'intérieur du trou. Un trou métallisé de type traversant 201 permet notamment de connecter électriquement toutes les couches conductrices 100 mises en œuvre, en particulier les deux couches en surface 101.

A l'étape 53, un ou plusieurs trous métallisés de type traversant 201 sont transformés en un ou plusieurs trous de type contre-percé 202 en supprimant, c'est-à-dire en éliminant, la métallisation inutile selon une direction perpendiculaire au plan d'empilement. Ainsi, un trou de type contre-percé 202 comprend une partie avec métallisation 2021 traversant perpendiculairement les couches conductrices 100 à connecter et s'ouvrant sur l'une des deux couches en surface 101. Le trou de type contre-percé 202 comprend en outre une partie sans métallisation 2022 traversant les autres couches conductrices 100 et s'ouvrant sur l'autre couche en surface 101. Il est à signaler que les trous de type contre-percé 202 selon les modes de réalisation de l'invention sont vides, c'est-à-dire qu'ils ne sont pas remplis par aucune résine de bouchage tel que décrit en relation avec les solutions de l'état de la technique.

A l'étape 54, des pistes électriques 302 et des pastilles de connexion 303 sont réalisées sur l'une ou sur les deux couches en surface 101 de la carte de circuits imprimés multicouche 10.

A l'étape 55, des pastilles métalliques 301 sont assemblées, c'est-à-dire fixées de manière rigide ou reportées, sur l'une ou sur les deux couches en surface 101 de manière à venir occulter chaque trou de type contre-percé 202 au niveau de sa partie sans métallisation 2022. Les pastilles métalliques 301 peuvent toutes être identiques. Alternativement, au moins deux pastilles métalliques 301 peuvent être différentes en termes de propriétés géométriques et/ou en termes de propriétés électriques.

A l'étape 56, des composants électroniques 304 sont assemblées sur des pastilles de connexion 303 réalisées sur l'une ou sur les deux couches en surface 101. L'homme du métier comprendra que les étapes 55 et 56 peuvent être mises en œuvre de manière parallèle ou séquentielle dans le temps.

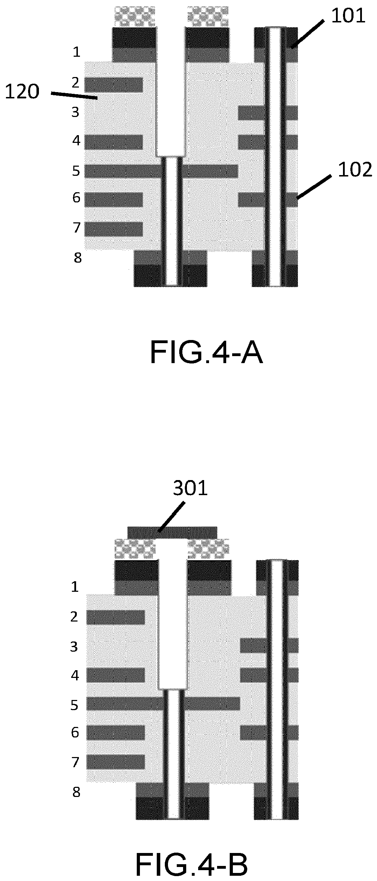

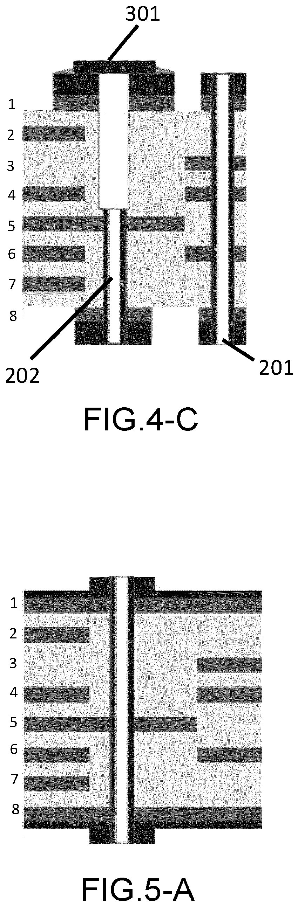

Les figures 4-A, 4-B, et 4-C illustrent les étapes mises en œuvre pour assembler une pastille métallique 301 sur l'une des deux couches en surface 101 de la carte de circuits imprimés multicouche 10 (étape 55 écrite ci-avant). Plus précisément, la figure 4-A illustre une première étape consistant à déposer une crème à braser sur une partie métallique de la couche en surface 101 destinée à accueillir la pastille métallique 301, la partie métallique pouvant, par exemple et sans limitation, être une pastille de connexion 303. La figure 4-B montre une deuxième étape consistant à poser la pastille métallique 301 sur la partie métallique de la couche en surface 101 préalablement préparée. La deuxième étape peut être mise en œuvre manuellement ou de manière automatisée en utilisant une machine de placement de composants montés en surface (CMS). La figure 4-C illustre une troisième étape de brasage consistant à fixer de manière rigide la pastille métallique 301 sur la couche en surface 101 de la carte de circuits imprimés multicouche 10. L'étape de brasage peut être mise en œuvre en utilisant la technique de brasage par refusion. Par ailleurs, le dépôt de la crème à braser (première étape) et la refusion (troisième étape) peuvent être réalisées en même temps pour les pastilles métalliques 301 et pour les composants électroniques 304.

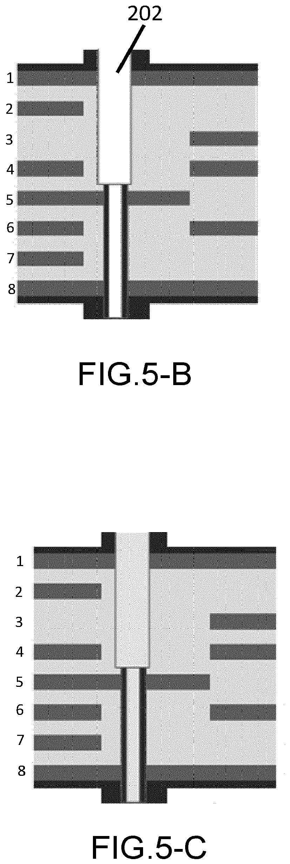

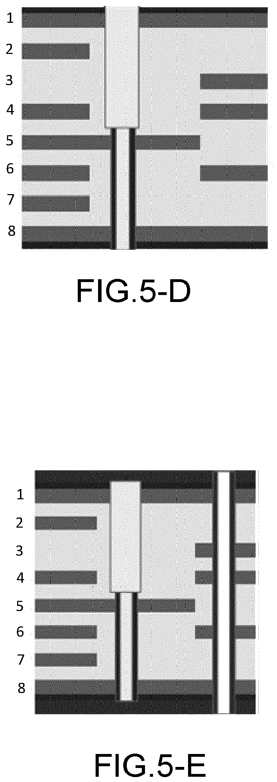

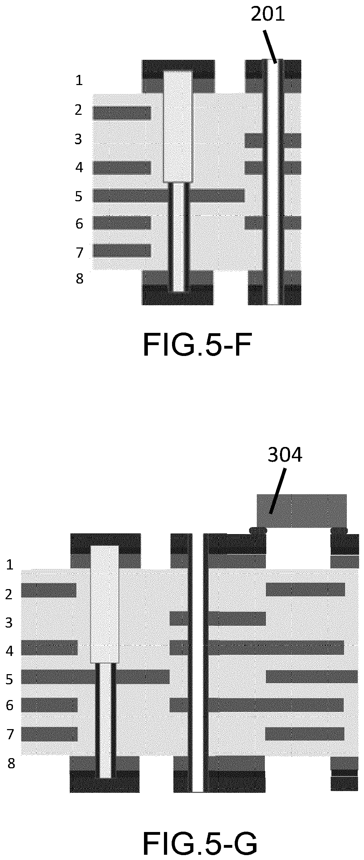

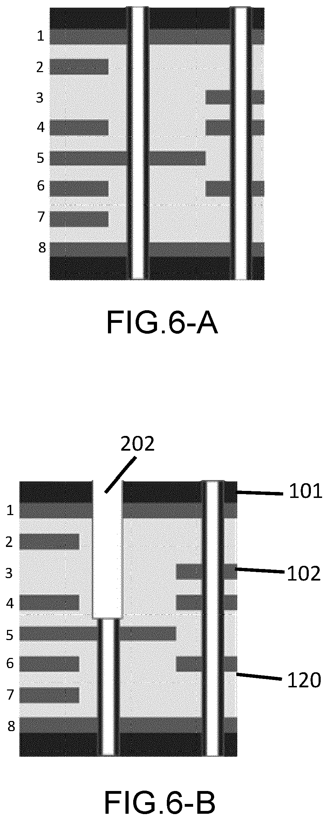

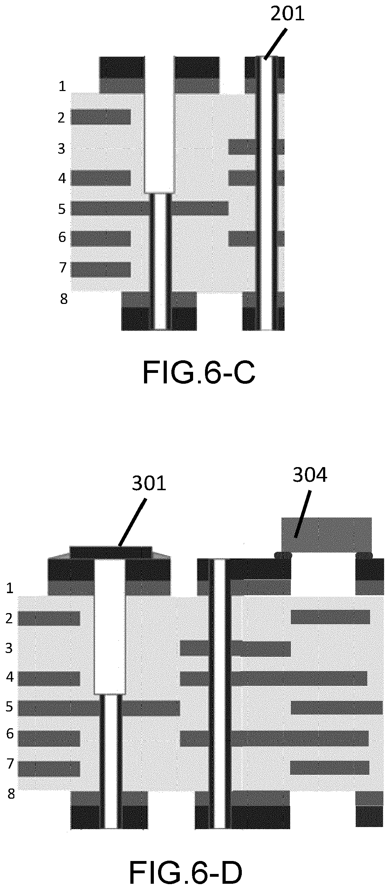

Les figures 5-A, 5-B, 5-C, 5-D, 5-E, 5-F et 5-G illustrent la réalisation d'un trou de type contre-percé 202 et d'un trou métallisé de type traversant 201 dans une carte de circuits imprimés multicouche 10 selon une solution de l'état de la technique. La solution de l'état de la technique consiste à remplir le trou de type contre-percé 202 par une résine non conductrice d'électricité avant de fermer le trou de type contre-percé 202 au moyen d'une métallisation. Les figures 6-A, 6-B, 6-C et 6-D illustrent les étapes requises pour réaliser le trou de type contre-percé 202 et le trou métallisé de type traversant 201 selon des modes de réalisation de l'invention.

Les figures 5-A et 6-A correspondent à une étape de perçage et de métallisation des trous permettant notamment de préparer le trou de type contre-percé 202 en réalisant un trou métallisé de type traversant 201. Plus précisément, la figure 6-A montre que la réalisation d'un trou de type contre-percé et la réalisation d'un trou métallisé de type traversant 201 peuvent démarrer dans une même étape de fabrication en réalisant deux trous métallisés de type traversant 201, selon les modes de réalisation de l'invention. Par ailleurs, la figure 5-A montre que la solution de l'état de la technique ne privilégie pas un tel parallélisme dans la réalisation d'un trou métallisé de type traversant 201 et d'un trou de type contre-percé 202.

Les figures 5-B et 6-B correspondent à une étape de contre-perçage consistant à réaliser un trou de type contre-percé 202 à partir d'un trou métallisé de type traversant 201. Ceci revient à supprimer une partie de la métallisation du trou métallisé de type traversant 201 selon une direction perpendiculaire au plan d'empilement de couches.

La figure 5-C correspond à une étape de remplissage mise en œuvre dans la solution de l'état de la technique, l'étape de remplissage consistant à remplir de manière complète le trou de type contre-percé 202 ainsi obtenu par une résine non conductrice d'électricité.

La figure 5-D correspond à une étape d'arasage mise en œuvre dans la solution de l'état de la technique, l'étape d'arasage consistant à aplanir les deux couches en surface 101 de la carte de circuits imprimés multicouche 10.

La figure 5-E illustre une étape de dépôt mise en œuvre dans la solution de l'état de la technique, l'étape de dépôt consistant à déposer une couche conductrice 100 d'électricité sur les deux couches en surface 101 déjà aplanies. L'étape de dépôt permet notamment de venir occulter le trou de type contre-percé 202 pour empêcher des rayonnements électromagnétiques parasites de se propager à l'extérieur du trou de type contre-percé 202 et/ou de pénétrer à l'intérieur du trou de type contre-percé 202. La figure 5-E illustre en outre une nouvelle mise en œuvre de l'étape de perçage et de métallisation des trous (décrite en relation avec la figure 6-A) pour réaliser un trou métallisé de type traversant 201. La réalisation d'un trou métallisé de type traversant 201 selon la solution de l'état de la technique ne peut se faire qu'après le remplissage et le bouchage des trous de type contre-percé 202. Ceci permet d'éviter le remplissage des trous métallisés de type traversant 201 par la résine non conductrice d'électricité.

La figure 5-F illustre une étape de gravure mise en œuvre dans la solution de l'état de la technique, l'étape de gravure consistant à réaliser des pistes électriques 302 et/ou des pastilles de connexion 303 sur l'une ou sur les deux couches en surface 101. L'étape de gravure permet notamment d'isoler électriquement la métallisation qui occulte chaque trou de type contre-percé 202.

La figure 5-G illustre une étape de report de composants électroniques 304 mise en œuvre dans la solution de l'état de la technique, l'étape de report de composants électroniques 304 consistant à assembler des composants électroniques 304 sur l'une ou sur les deux couches en surface 101. Plus précisément, chaque composant électronique 304 peut être assemblé sur deux ou plusieurs pastilles de connexion 303 dédiées.

En continuité avec les étapes de fabrication selon des modes de réalisation de l'invention, la figure 6-C correspond à une étape de gravure consistant à réaliser des pistes électriques 302 et/ou des pastilles de connexion 303 sur l'une ou sur les deux couches en surface 101.

La figure 6-D correspond à une étape de report de composants électriques consistant à assembler des composants électroniques 304 sur l'une ou sur les deux couches en surface 101. Parmi les composants électroniques 304 assemblés à cette étape, il existe les pastilles métalliques 301 destinées à occulter les trous de type contre-percé 202. Les pastilles métalliques 301 peuvent donc être assemblées sur les couches en surface 101 de manière similaire à tout autre composant électronique 304 monté en surface.

Les modes de réalisation de l'invention permettent ainsi de réaliser l'isolation électrique dans les trous de type contre-percé 202 en requérant moins d'étapes de fabrication que les solutions de l'état de la technique et assurent donc un meilleur rendement de fabrication. En outre, les modes de réalisation de l'invention permettent une isolation électrique dans les trous de type contre-percé 202 sans requérir le remplissage de tels trous de type contre-percé 202 par une résine non conductrice. Ceci permet un gain, par exemple, en masse. Par ailleurs, contrairement aux solutions de l'état de la technique qui nécessitent une étape de dépôt d'une couche conductrice 100 supplémentaire (Figure 5-E) sur la ou les couches en surface 101 pour occulter les trous de type contre-percé 202, les modes de réalisation de l'invention permettent de conserver l'épaisseur initiale des couches conductrices 100 en surface, ce qui permet un gain en termes de précision de gravure et en termes de masse.

L'invention n'est pas limitée aux modes de réalisation décrits ci-avant à titre d'exemple non limitatif. En particulier, l'invention n'est pas limitée aux exemples de systèmes électroniques cités dans la description. Elle englobe toutes les variantes de réalisation qui pourront être envisagées par l'homme du métier.

## Revendications

1. Carte de circuits imprimés multicouche (10) destinée à connecter des composants électroniques (304), la carte de circuits imprimés multicouche (10) comprenant un empilement de plusieurs couches conductrices (100), les couches conductrices (100) comprenant deux couches en surface (101) et une ou plusieurs couches internes (102), la séparation entre deux couches conductrices (100) voisines étant assurée au moyen d'une couche électriquement isolante (120), la carte de circuits imprimés comprenant un ou plusieurs trous de type contre-percé (202), chaque trou de type contre-percé (202) étant configuré pour connecter électriquement l'une des deux couches en surface (101) à une ou à plusieurs couches internes (102) et comprenant une partie avec métallisation (2021) s'ouvrant sur l'une des deux couches en surface (101) et une partie sans métallisation (2022) s'ouvrant sur l'autre couche en surface (101), la partie avec métallisation (2021) et la partie sans métallisation (2022) d'un trou de type contre-percé (202) s'étendant dans une direction perpendiculaire à un plan d'empilement de couches, **caractérisée en ce que** la carte de circuits imprimés multicouche (10) comprend en outre une ou plusieurs pastilles métalliques (301), chaque pastille métallique (301) étant assemblée sur l'une des deux couches en surface (101) de manière à venir occulter un trou de type contre-percé (202) correspondant au niveau de sa partie sans métallisation (2022).

2. Carte de circuits imprimés multicouche (10) selon la revendication 1, **caractérisée en ce que** des rayonnements électromagnétiques parasites sont susceptibles de se former à l'intérieur desdits trous de type contre-percé (202), et **en ce que** lesdites pastilles métalliques (301) sont choisies de manière à bloquer, au moins partiellement, la propagation desdits rayonnements électromagnétiques parasites en dehors desdits trous de type contre-percé (202).

3. Carte de circuits imprimés multicouche (10) selon l'une quelconque des revendications 1 et 2, **caractérisée en ce que** des rayonnements électromagnétiques parasites sont susceptibles de pénétrer à l'intérieur desdits trous de type contre-percé (202), et **en ce que** lesdites pastilles métalliques (301) sont choisies de manière à bloquer, au moins partiellement, la propagation desdits rayonnements électromagnétiques parasites à l'intérieur desdits trous de type contre-percé (202).

4. Carte de circuits imprimés multicouche (10) selon l'une quelconque des revendications 2 et 3, **caractérisée en ce que** des propriétés géométriques d'une pastille métallique (301) sont choisies en fonction d'une ou plusieurs caractéristiques des rayonnements électromagnétiques parasites susceptibles de se former et/ou de pénétrer dans le trou de type contre-percé (202) correspondant.

5. Carte de circuits imprimés multicouche (10) selon l'une quelconque des revendications 2 à 4, **caractérisée en ce que** des propriétés électriques d'une pastille métallique (301) sont choisies en fonction d'une ou plusieurs caractéristiques des rayonnements électromagnétiques parasites susceptibles de se former et/ou de pénétrer dans le trou de type contre-percé (202) correspondant.

6. Carte de circuits imprimés multicouche (10) selon l'une quelconque des revendications 1 à 3, **caractérisée en ce que** lesdites pastilles métalliques (301) sont identiques.

7. Carte de circuits imprimés multicouche (10) selon l'une quelconque des revendications précédentes, **caractérisée en ce que** lesdites pastilles métalliques (301) sont des composants passifs ne requérant pas une alimentation électrique.

8. Procédé de fabrication d'une carte de circuits imprimés multicouche (10) et de report de composants, la carte de circuits imprimés multicouche (10) étant destinée à connecter des composants électroniques (304), **caractérisé en ce qu'**il comprend les étapes consistant à :
- réaliser (51) un empilement de plusieurs couches conductrices (100), les couches conductrices (100) comprenant deux couches en surface (101) et une ou plusieurs couches internes (102), la séparation entre deux couches conductrices (100) voisines étant assurée au moyen d'une couche isolante (120) ;
- réaliser (52) des connexions électriques entre lesdites couches conductrices (100) au moyen d'un ou plusieurs trous métallisés de type traversant (201) ;
- transformer (53) au moins un trou métallisé de type traversant (201) en un trou de type contre-percé (202), sans remplir le trou de type contre-percé (202) par une résine de bouchage, le trou de type contre-percé (202) comprenant une partie avec métallisation (2021) s'ouvrant sur l'une des deux couches en surface (101) et une partie sans métallisation (2022) s'ouvrant sur l'autre couche en surface (101), la partie avec métallisation (2021) et la partie sans métallisation (2022) d'un trou de type contre-percé (202) s'étendant dans une direction perpendiculaire à un plan d'empilement de couches ;
- réaliser (54) des pistes électriques (302) et des pastilles de connexion (303) sur au moins l'une des deux couches en surface (101).

9. Procédé de fabrication d'une carte de circuits imprimés multicouche (10) et de report de composants selon la revendication 8, **caractérisé en ce qu'**il comprend en outre des étapes consistant à :
- assembler (55) une ou plusieurs pastilles métalliques (301) sur l'une ou sur les deux couches en surface (101), chaque pastille métallique (301) étant assemblée de manière à venir occulter un trou de type contre-percé (202) correspondant au niveau de sa partie sans métallisation (2022).
- assembler (56) un ou plusieurs composants électroniques (304) sur des pastilles de connexion (303) appartenant à l'une ou aux deux couches en surface (101).
